# EUROPÄISCHE PATENTSCHRIFT

(11) **EP 0 654 149 B1**
(45) Veröffentlichungstag und Bekanntmachung des Hinweises auf die Patenterteilung: **05.02.1997**
(21) Anmeldenummer: 93912903.7
(22) Anmeldetag: 07.06.1993
(51) Int. Cl.: G03F 7/004, C07C 315/04

(54) **POSITIV-ARBEITENDES STRAHLUNGSEMPFINDLICHES GEMISCH UND DAMIT HERGESTELLTES AUFZEICHNUNGSMATERIAL**
POSITIVE-ACTING RADIATION-SENSITIVE MIXTURE AND RECORDING MATERIAL PRODUCED THEREWITH
MELANGE SENSIBLE AU RAYONNEMENT, A FONCTION POSITIVE, ET MATERIAU D'ENREGISTREMENT FABRIQUE AVEC CE MELANGE

(30) Priorität: 05.08.1992 DE 4225830
(43) Veröffentlichungstag der Anmeldung: 24.05.1995
(73) Patentinhaber: HOECHST AKTIENGESELLSCHAFT, 65926 Frankfurt am Main (DE)
(72) Erfinder: WENGENROTH, Horst, D-56457 Westerburg (DE); SPIESS, Walter, D-64807 Dieburg (DE); BUHR, Gerhard, D-61462 Königstein (DE); RÖSCHERT, Horst, D-55437 Ober-Hilbersheim (DE); PAWLOWSKI, Georg, D-65187 Wiesbaden (DE); FUCHS, Jürgen, D-65439 Flörsheim (DE)
(86) Internationale Anmeldenummer: EP9301431
(87) Internationale Veröffentlichungsnummer: WO9403837

(56) Entgegenhaltungen:
- DE-A- 4 111 060
- GB-A- 1 204 495
- CANADIAN JOURNAL OF CHEMISTRY Bd. 58, Nr. 6, 15. M rz 1978, R.F. LANGLER ET AL. 'The photochemistry of benzylic sulfonyl compounds : The preparation of sulfones and sulfinic acids' in der Anmeldung erw hnt

## Beschreibung

Die Erfindung betrifft ein positiv-arbeitendes strahlungsempfindlichen Gemisch, das
a) eine Verbindung, die unter Einwirkung von Strahlung
eine starke Säure bildet, b) eine Verbindung mit mindestens einer durch Säure
spaltbaren C-O-C- oder C-O-Si-Bindung und c) ein in Wasser unlösliches, in wäßrig-alkalischen Lösungen lösliches oder zumindest quellbares Bindemittel
enthält, sowie ein damit hergestelltes strahlungsempfindliches Aufzeichnungsmaterial, das für Photoresists und elektronische Bauteile geeignet ist.

Als Verbindungen, die bei Bestrahlung eine starke Säure bilden, wurden bisher insbesondere Onium-Salze, wie Diazonium-, Phosphonium-, Sulfonium- und Jodonium-Salze von nicht nucleophilen Säuren, wie HSbF₆, HAsF₆, oder HPF₆ [J.V. Crivello, Polym. Eng. Sci., 23 (1983) 953], verwendet. Daneben sind Halogenverbindungen, insbesondere Trichlormethyltriazin-Derivate oder Trichlormethyloxadiazol-Derivate, o-Chinondiazidsulfochloride, o-Chinondiazid-4-sulfonsäureester, Organometall-Organohalogen-Kombinationen, Bis(sulfonyl)diazomethane, Sulfonyl-carbonyl-diazomethane (DE-A 39 30 087) oder Nitrobenzyltosylate [F.M. Houlihan et al., SPIE Proc., Adv. in Resist Techn. and Proc. 920 (1988) 67] empfohlen worden. Diese Verbindungen werden in negativ oder positiv-arbeitenden strahlungsempfindlichen Gemischen verwendet. Die Verwendung derartiger photolytischer Säurebildner bringt aber gewisse Nachteile mit sich, die ihre Einsatzmöglichkeiten in verschiedenen Anwendungsbereichen drastisch einschränken. So sind z.B. viele der Oniumsalze toxisch. Ihre Löslichkeit ist in vielen Lösemitteln unzureichend, weshalb nur wenige Lösemittel zur Herstellung einer Beschichtungslösung geeignet sind. Darüber hinaus werden bei Verwendung der Oniumsalze z.T. unerwünschte Fremdatome eingeführt, die insbesondere in der Mikrolithographie zu Prozeßstörungen führen können. Ferner bilden die Oniumsalze bei der Photolyse sehr stark korrodierend wirkende Brønsted-Säuren. Diese Säuren greifen empfindliche Substrate an, so daß der Einsatz solcher Gemische zu unbefriedigenden Ergebnissen führt. Wie bereits früher erwähnt, bilden auch die Halogenverbindungen sowie die Chinondiazidsulfonsäurechloride stark korrosiv wirkende Halogenwasserstoffsäuren. Ferner besitzen derartige Verbindungen auf bestimmten Substraten nur eine begrenzte Haltbarkeit, die dadurch verbessert wurde, daß zwischen Substrat und strahlungsempfindlicher, Verbindungen des Typs (a) enthaltender Schicht eine Zwischenschicht eingefügt wurde, was allerdings zu einer unerwünschten Zunahme von Defekten und zu einer verminderten Reproduzierbarkeit führte (DE-A 36 21 376 = US-A 4 840 867).

In neueren Arbeiten von F.M. Houlihan et al., SPIE 920, 67 (1988) wurde anhand positiv-arbeitender Systeme gezeigt, daß neben den oben genannten Säurebildnern auch Nitrobenzyltosylate, die bei Belichtung Sulfonsäuren mit geringer Wanderungstendenz bilden, in bestimmten säurelabilen Resistformulierungen verwendbar sind. Die dabei erzielten Empfindlichkeiten und die thermische Stabilität der Photoresists erwiesen sich jedoch als unzureichend.

Die a-Sulfonyldiazomethane bilden unter der Einwirkung aktinischer Strahlung wenig bewegliche Sulfonsäuren, sie besitzen jedoch nur eine unzureichende thermische Stabilität und eine unerwünscht hohe Absorption im UV-Bereich. Die in der DE-A 41 11 060 offenbarten Disulfone der allgemeinen Formel R-SO₂-SO₂-R' zeigen gleichfalls eine hohe Absorption in diesem Bereich. Darüber hinaus sind sie in vielen der üblicherweise verwendeten Lösemittel nur schlecht löslich.

Bereits bekannt sind auch Resistformulierungen mit Naphthochinon-2-diazid-4-sulfonsäureestern, Oximsulfonaten, 1,2-Disulfonen, Bis-sulfonyl-diazomethan (DE-A 39 30 086) und Sulfonyl-carbonyl-diazomethan (DE-A 39 30 087). All diese Verbindungen bilden unter der Einwirkung aktinischer Strahlung nicht korrodierend wirkende Sulfonsäuren. Die photochemischen Reaktionen verlaufen mit weitgehend zufriedenstellenden Quantenausbeuten. Die Resistformulierungen mit diesen Verbindungen absorbieren Strahlung der Wellenlänge 248 nm jedoch in beträchtlichem Maße. Die Empfindlichkeit gegenüber Strahlung dieser Wellenlänge liegt im Bereich von 50 bis 100 mJ/cm². Praxisgerechte Strukturen einer Größenordnung von 0,5 µm und weniger lassen sich mit solchen Resists nicht abbilden.

Weiterhin ist bekannt, daß β-Keto-sulfone bei Bestrahlung Sulfinsäuren oder Sulfonsäuren liefern (Tsunooka et al., J. Photopolym. Sci. Tech. **4** [1991] 239 - 242; Tsunooka et al., Makromol. Chem., Rapid Comm. **4** [1983] 539 - 541; McIntosh et al., Tetrahedron Letters **1967**, 37).

In der GB-A 1 204 492 ist ein Aufzeichnungsmaterial mit einem Träger und einer wärme- und lichtempfindlichen Schicht beschrieben. Die Schicht enthält eine Verbindung, die beim Erhitzen oder Bestrahlen Radikale produziert. Die Radikale verändern die Schicht an den erhitzten oder bestrahlten Stellen, so daß diese auf chemischem oder physikalischem Weg sichtbar gemacht werden können. Gegebenenfalls enthält die Schicht noch eine Verbindung, die in Gegenwart der Radikale vernetzt oder polymerisiert. Die konkret offenbarten Radikalbildner sind 2-Benzolsulfonyl-1,3-diketone. Daneben sind auch 2-Naphthalin-l-yl-2-nitro-indan-1,3-dion, (4-Nitrobenzoyl)-malodinitril, 2,2-Diazido-indan-1,3-dion und 2-Jod-1,3-diphenyl-propan-1,3-dion genannt.

Langler et al. (Can. J. Chem. **65** [1978] 903 - 907) haben das photochemische Verhalten von benzyl-substitierten β-Disulfon-Verbindungen untersucht und dabei festgestellt, daß diese unter der Einwirkung von Strahlung zunächst in ein Benzylradikal und ein β-Disulfonradikal zerfallen. Letzteres nimmt ein Wasserstoffradikal auf, wodurch intermediär eine Sulfinsäure gebildet wird, und spaltet dann in einem ionischen Mechanismus Schwefeldioxid ab, so daß ein Sulfon zurückbleibt. Benzylsulfone bilden bei Bestrahlung in ähnlicher Weise Benzylradikale und Sulfonylradikale, aus denen dann Sulfinsäuren hervorgehen. Die Ausbeute an Sulfinsäuren steigt, wenn die Bestrahlung in Isopropanol an Stelle von Methanol ausgeführt wird.

Trotz der bisher geleisteten intensiven Forschungstätigkeit auf diesem Gebiet ist derzeit kein strahlungsempfindliches Gemisch bekannt, mit dem sich ein positiv-arbeitendes strahlungsempfindliches Aufzeichnungsmaterial herstellen läßt, das eine hohe Empfindlichkeit im DUV-Bereich (200 bis 300 nm) sowie eine hohe Auflösung besitzt, bereits bei kurzzeitiger Bestrahlung eine ausreichende Menge einer nicht korrodierend wirkenden Säure freisetzt, die stark genug ist, um Verbindungen des Typs b) zu spalten und das zudem noch wäßrig-alkalisch entwickelbar ist.

Aufgabe der Erfindung war es daher, ein strahlungsempfindliches Gemisch auf der Basis von säurebildenden in Kombination mit säurespaltbaren Verbindungen vorzuschlagen, wobei die photolytisch eine Säure bildende Verbindung (a) möglichst stabil auf allen bekannten Substraten sein soll und als Photoprodukt eine nicht korrosiv wirkende Säure liefert.

Die Aufgabe wird gelöst durch ein positiv-arbeitendes strahlungsempfindliches Gemisch mit
a) einer Verbindung, die unter Einwirkung von aktinischer Strahlung Säure bildet,
b) einer Verbindung mit mindestens einer durch diese Säure spaltbaren C-O-C- oder C-O-Si-Bindung und
c) einem in Wasser unlöslichen, in wäßrig-alkalischen Lösungen löslichen oder zumindest quellbaren polymeren Bindemittel,
das dadurch gekennzeichnet ist, daß die Verbindung (a) der allgemeinen Formel

R¹(-SO₂-R²)ₙ

entspricht, worin
- R¹: ein n-wertiger (C₁-C₃)Alkanrest ist,
- R²: gleich oder verschieden sind und Aryl-, Aralkyl-, Heteroaryl- oder Heteroaralkylreste und
- n: eine ganze Zahl von 2 bis 4
bedeuten. R¹ ist bevorzugt Methylen, Ethan-1,1-diyl, Ethan-1,2-diyl, Propan-1,2-diyl, Isopropyliden, Propan-1,3-diyl, Methantriyl, Ethan-1,1,1-triyl oder Ethan-1,1,2-triyl oder Propan-1,1,3,3-tetrayl. Besonders bevorzugt ist R¹ Methylen, Ethan-1,2-diyl oder Propan-1,3-diyl.

Der Rest R¹ kann substituiert sein, insbesondere mit Alkyl-, Cycloalkyl-, Aryl-, Heteroaryl- und/oder Acylresten. Bevorzugte Substituenten sind geradkettige oder verzweigte (C₁-C₁₂)Alkylreste.

R² ist bevorzugt Phenyl, Naphthalin-1-yl, Naphthalin-2-yl oder Benzyl. Von den Heteroaryl- und Heteroaralkylresten sind solche mit einem Stickstoff-, Sauerstoff- oder Schwefelatom als Heteroatom im aromatischen Ringsystem bevorzugt.

Die Reste R² können ebenfalls substituiert sein, insbesondere mit geradkettigen oder verzweigten (C₁-C₄)Alkyl-oder (C₁-C₄)Alkoxyresten, Alkoxyalkyl, Alkanoyl, Alkanoylamino, Carboxy, Aryl, Aryloxy, Aroyl, Aroylamino, Aralkoxy, Cyano, Nitro, Fluor-, Chlor- und/oder Bromatomen. In den (Hetero)aralkylresten sind diese Substituenten allgemein an den aromatische Teil gebunden.

Besonders geeignete Verbindungen der allgemeinen Formel sind Bis-benzolsulfonyl-methan, Bis-(toluol-4-sulfonyl)-methan, Bis-(3,4-dimethyl-benzolsulfonyl)-methan, Bis-(3-methoxy-benzolsulfonyl)-methan, Bis-(3-chlor-benzolsulfonyl)-methan, Bis-(4-chlor-benzolsulfonyl)-methan, Bis-(3,5-dichlor-benzolsulfonyl)-methan, Bis-(4-brom-benzolsulfonyl)-methan, Bis-(4-fluor-benzolsulfonyl)-methan, l,l-Bis-benzolsulfonyl-ethan, 1,2-Bis-benzolsulfonylethan, α,α-Bis-benzolsulfonyl-toluol, 2-Benzolsulfonyl-2-phenylmethansulfonyl-propan, 2,2-Bis-phenylmethansulfonylpropan, l,l,l-Tris-benzolsulfonyl-ethan, 1,1,1-Tris-(4-brom-benzolsulfonyl)-ethan, 1,1,1-Tris-(toluol-4-sulfonyl)-ethan, 1,1,3,3-Tetrakis-(4-chlor-benzolsulfonyl)-propan, 1,1,3,3-Tetrakis-(4-brom-benzolsulfonyl)-propan und 1,1,3,3-Tetrakis-(4-tert.-butyl-benzolsulfonyl)-propan.

Diese Verbindungen liefern Säuren, vorwiegend Sulfinsäuren, mit einer hohen Quantenausbeute und sind zudem ausreichend thermisch stabil. Eine Anzahl der Verbindungen der allgemeinen Formel ist bereits bekannt.

Herstellen lassen sich diese Verbindungen in für den Fachmann an sich bekannten Verfahren (F. Klages et al., Chem. Ber. **97** [1964] 735; G. Ferdinand et al., Liebigs Ann. Chem. **1976** 1713).

Es war überraschend, daß die in den erfindungsgemäßen Gemischen eingesetzten Verbindungen der allgemeinen Formel unter der Einwirkung von Strahlung eine genügende Menge an ausreichend starker Säure liefern. Besonders überraschend war es, daß die Verbindungen der allgemeinen Formel auch unter der Einwirkung von UV-2-Strahlung, insbesondere von Strahlung mit einer Wellenlänge von 248 nm, in ausreichendem Maße Säure liefern, nachdem bekannt war, daß sie in diesem Wellenlängenbereich nur wenig absorbieren (die Absorption bei 248 nm beträgt weniger als 0,1µm⁻¹). Vorzugsweise zeigen die Verbindungen der allgemeinen Formel von allen Resistbestandteilen die höchste molare Absorption.

Das erfindungsgemäße, strahlungsempfindliche Gemisch zeichnet sich durch eine hohe Empfindlichkeit aus. Es zeigt eine hohe thermische Stabilität und schafft die Möglichkeit, auch feinste Strukturen einer Vorlage detailgenau wiederzugeben. Die bei der Bestrahlung gebildete Säure wirkt nicht korrodierend, so daß das Gemisch auch auf empfindlichen Substratmaterialien Verwendung finden kann.

Zum bildmäßigen Bestrahlen ist insbesondere UV-Strahlung im Bereich von 190 bis 260 nm, bevorzugt von 200 bis 250 nm, aber auch Elektronen- oder Röntgenstrahlung geeignet.

In dem erfindungsgemäßen Gemisch können auch verschiedene Verbindungen der allgemeinen Formel als Säurebildner enthalten sein. Daneben können auch noch andere Säurebildner Verwendung finden. Solche zusätzlichen Säurebildner sind z.B. die in der DE-A 41 12 971 beschriebenen mehrfunktionellen Sulfonsäureester von 2,4,6-Tris-(2-hydroxy-ethoxy)-[1,3,5]triazin. Darüber hinaus sind 1,2-Disulfone, Bis(sulfonyl)diazomethane und Sulfonyl-carbonyldiazomethane geeignet. Gemische mit solchen zusätzlichen Säurebildnern sind jedoch nicht bevorzugt.

Der Anteil an säurebildenden Verbindungen insgesamt wie auch der an Verbindungen der allgemeinen Formel im erfindungsgemäßen Gemisch liegt im allgemeinen bei 0,5 bis 25 Gew.-%, bevorzugt bei 1 bis 10 Gew.-%, jeweils bezogen auf das Gesamtgewicht der nichtflüchtigen Bestandteile im Gemisch.
Als säurespaltbare Verbindungen b) in dem erfindungsgemäßen, strahlungsempfindlichen Gemisch haben sich vor allem solche aus einer der folgende Verbindungsklassen bewährt:
a) Verbindungen mit mindestens einer Orthocarbonsäure-ester- und bzw. oder Carbonsäureamidacetalgruppe, wobei die Verbindungen auch polymeren Charakter haben und die genannten Gruppen in der Hauptkette oder seitenständig auftreten können,
b) oligomere oder polymere Verbindungen mit wiederkehrenden Acetal- und/oder Ketalgruppen in der Hauptkette,
c) Verbindungen mit mindestens einer Enolether- oder N-Acyliminocarbonatgruppe,
d) cyclische Acetale oder Ketale von β-Ketoestern oder-amiden,
e) Verbindungen mit Silylethergruppen,
f) Verbindungen mit Silylenolethergruppen,
g) Monoacetale bzw. Monoketale von Aldehyden bzw. Ketonen, deren Löslichkeit im Entwickler zwischen 0,1 und 100 g/l beträgt,
h) Ether abgeleitet aus tertiären Alkoholen,
i) Carbonsäureester und Carbonate, deren Alkoholkomponente ein tertiärer Alkohol, ein Allylalkohol oder ein Benzylalkohol ist, und
j) N,O-Acetale, insbesondere N,O-Polyacetale.

Es können auch Mischungen der vorgenannten säurespaltbaren Verbindungen eingesetzt werden. Von den genannten Verbindungen sind besonders die mit mindestens einer durch Säure spaltbaren C-O-C-Bindung bevorzugt, d. h. die Verbindungen der Klassen (a), (b), (g) und (i) und (j). Unter Typ (b) sind besonders die polymeren Acetale hervorzuheben; von den säurespaltbaren Materialien des Typs (g) insbesondere diejenigen, die sich von Aldehyden bzw. Ketonen mit einem Siedepunkt über 150 °C, vorzugsweise über 200 °C, ableiten. Gemische mit verschiedenen säurespaltbaren Verbindungen sind allgemein nicht bevorzugt.

Der Anteil der Verbindung(en) b) liegt allgemein bei 1 bis 50 Gew.-%, bevorzugt 10 bis 40 Gew.-%, jeweils bezogen auf das Gesamtgewicht der Feststoffe des strahlungsempfindlichen Gemisches.

Das erfindungsgemäße strahlungsempfindliche Gemisch enthält ferner mindestens ein polymeres, in Wasser unlösliches, in wäßrig-alkalischen Lösungen dagegen lösliches, zumindest quellbares Bindemittel c). Das Bindemittel zeichnet sich im besonderen dadurch aus, daß es mit den übrigen Bestandteilen des erfindungsgemäßen strahlungsempfindlichen Gemisches gut verträglich ist und insbesondere im Wellenlängenbereich von 190 bis 300 nm eine möglichst geringe Eigenabsorption, d.h. eine hohe Transparenz, aufweist. Bindemittel auf der Basis von Novolak-Kondensationsharzen, die in der Regel in Kombination mit Naphthochinondiaziden als photoaktive Komponenten eingesetzt werden, erfüllen diese Bedingung nicht. Zwar lassen Novolak-Kondensationsharze nach bildmäßiger Belichtung in den nicht belichteten Bereichen eine Reduzierung der Löslichkeit gegenüber wäßrig-alkalischen Entwicklern erkennen, doch ist ihre Eigenabsorption im Bereich der für die Bestrahlung gewünschten kurzen Wellenlänge unerwünscht hoch.

Novolak-Kondensationsharze können aber in Mischung mit anderen als Bindemittel geeigneten Harzen mit höherer Transparenz eingesetzt werden. Die Mischungsverhältnisse richten sich dabei vorwiegend nach der Art des mit dem Novolakharz zu mischenden Bindemittels. Insbesondere spielen dessen Grad an Eigenabsorption im genannten Wellenlängenbereich, aber auch die Mischbarkeit mit den anderen Bestandteilen des strahlungsempfindlichen Gemisches eine entscheidende Rolle. Im allgemeinen kann aber das Bindemittel des erfindungsgemäßen strahlungsempfindlichen Gemisches bis zu 30 Gew.-%, insbesondere bis zu 20 Gew.-%, eines Novolak-Kondensationsharzes enthalten.

Als Bindemittel geeignet sind Homo- oder Copolymere des 4-Hydroxystyrols sowie seiner Alkylderivate, z.B. des 3-Methyl-4-hydroxystyrols, sowie Homo- oder Copolymere anderer Vinylphenole, z. B. des 3-Hydroxystyrols oder der Ester oder Amide von Acrylsäure mit phenolischen Gruppen aufweisenden Aromaten. Als Comonomere können polymerisierbare Verbindungen wie Styrol, Methyl(meth)acrylat oder ähnliche eingesetzt werden.

Schichten mit erhöhter Plasmabeständigkeit erhält man, wenn darin siliciumhaltige Bindemittel, z. B. aus Vinyltrimethylsilan, verwendet werden. Die Transparenz dieser Bindemittel ist im Deep-UV-Bereich im allgemeinen höher, so daß eine verbesserte Strukturierung möglich ist.

Mit gleichem Erfolg lassen sich auch Homo- oder Copolymere des Maleinimids verwenden. Auch diese Bindemittel zeigen hohe Transparenz im Deep-UV-Bereich. Als Comonomere werden auch hier bevorzugt Styrol, substituierte Styrole, Vinylether, Vinylester, Vinylsilylverbindungen oder (Meth)-acrylsäureester eingesetzt.

Schließlich sind darüber hinaus auch Copolymere des Styrols mit Comonomeren verwendbar, die in wäßrig alkalischen Lösungen eine Löslichkeitserhöhung bewirken. Hierzu zählen beispielsweise Maleinsäureanhydrid und Maleinsäurehalbester.

Die genannten Bindemittel können auch untereinander gemischt werden, sofern sich dadurch die optische Qualität des strahlungsempfindlichen Gemisches nicht verschlechtert. Bindemittelgemische sind jedoch nicht bevorzugt.

Die Extinktion des Bindemittels bzw. der Kombination von Bindemitteln für Strahlung der Wellenlänge 248 nm beträgt bevorzugt weniger als 0,35, besonders bevorzugt weniger als 0,25 µm⁻¹.

Die Glasübergangstemperatur des Bindemittels bzw. der Kombination von Bindemitteln liegt vorteilhaft bei mindestens 120 °C.

Der Anteil des Bindemittels beträgt im allgemeinen 1 bis 98,5 Gew.-%, bevorzugt 25 bis 90 Gew.-%, besonders bevorzugt 50 bis 80 Gew.-%, jeweils bezogen auf das Gesamtgewicht der festen Anteile des strahlungsempfindlichen Gemisches.

Die erfindungsgemäßen Gemische können schließlich noch weitere Komponenten, wie Farbstoffe, Pigmente, Weichmacher, Netzmittel und Verlaufmittel enthalten. Zur Erfüllung spezieller Erfordernisse, wie Flexibilität, Haftung und Glanz, können noch Verbindungen, wie Polyglykol, Celluloseether, z. B. Ethylcellulose, zugesetzt sein.

Soll ein Substrat beschichtet werden, so wird das erfindungsgemäße strahlungsempfindliche Gemisch zweckmäßig in einem Lösemittel oder in einer Kombination von Lösemitteln gelöst. Hierfür besonders geeignet sind Glykole, wie Ethylenglykol und Propylenglykol sowie die davon abgeleiteten Mono- und Dialkylether, besonders die Mono- und Dimethylether sowie die Mono- und Diethylether, Ester abgeleitet aus aliphatischen (C₁-C₆)Carbonsäuren und entweder (C₁-C₈)ASkanolen oder (C₁-C₈)ASkandioaen oder (C₁-C₆)-Alkoxy-(C₁-C₈)alkanolen, beispielsweise Ethylacetat, Hydroxyethylacetat, Alkoxyethylacetat, n-Butylacetat, Propylenglykolmonoalkyletheracetat, insbesondere Propylenglykolmethyletheracetat und Amylacetat, Ether, wie Tetrahydrofuran und Dioxan, Ketone, wie Methylethylketon, Methylisobutylketon, Cyclopentanon und Cyclohexanon, N,N-Dialkyl-carbonsäureamide, wie N,N-Dimethylformamid und N,N-Dimethylacetamid, aber auch Hexamethylphosphorsäuretriamid, N-Methyl-pyrrolidin-2-on und Butyrolacton, sowie beliebige Mischungen davon. Besonders bevorzugt von diesen sind die Glykolether, aliphatischen Ester und Ketone.

Letztendlich hängt die Wahl des Lösemittels bzw. Lösemittelgemisches ab von dem angewandten Beschichtungsverfahren, der gewünschten Schichtstärke und den Trocknungsbedingungen. Ebenso müssen die Lösemittel unter den angewendeten Bedingungen gegenüber den übrigen Schichtbestandteilen chemisch inert sein.

Die mit den genannten Lösemitteln hergestellte Lösung hat in der Regel einen Feststoffgehalt von 5 bis 60 Gew.-%, vorzugsweise 10 bis 40 Gew.-%.

Gegenstand der Erfindung ist schließlich auch ein strahlungsempfindliches Aufzeichnungsmaterial, das im wesentlichen aus einem Substrat und einer darauf befindlichen strahlungsempfindlichen Schicht aus dem erfindungsgemäßen Gemisch besteht.

Als Substrate kommen alle Materialien in Frage, aus denen Kondensatoren, Halbleiter, mehrlagige gedruckte Schaltungen oder integrierte Schaltkreise bestehen bzw. hergestellt werden können. Speziell sind Siliciumsubstrate zu nennen, die auch thermisch oxidiert und/oder mit Aluminium beschichtet, aber auch dotiert sein können. Daneben sind alle anderen in der Halbleitertechnologie üblichen Substrate möglich, wie Siliciumnitrid, Galliumarsenid und Indiumphosphid. Diese Substrate können thermisch vorbehandelt, oberflächlich aufgerauht, angeätzt oder, zur Verbesserung erwünschter Eigenschaften, z. B. zur Erhöhung der Hydrophilie, mit Chemikalien vorbehandelt sein.

Um der strahlungsempfindlichen Schicht einen besseren Zusammenhalt und/oder eine bessere Haftung auf der Substratoberfläche zu verleihen, kann in ihr ein Haftvermittler enthalten sein. Bei Silicium- bzw. Siliciumdioxid-Substraten kommen hierfür Haftvermittler vom Aminosilan-Typ, wie z. B. 3-Aminopropyl-triethoxy-silan oder Hexamethyl-disilazan, in Frage.

Als Strahlungsquellen für die bildmäßige Bestrahlung eignen sich besonders Metallhalogenidlampen, Kohlebogenlampen, Xenonlampen und Quecksilberdampflampen. Ebenso kann eine Belichtung mit energiereicher Strahlung wie Laser-, Elektronen- oder Röntgenstrahlung erfolgen. Besonders bevorzugt sind jedoch Lampen, die Licht einer Wellenlänge von 190 bis 260 nm ausstrahlen können, d.h. insbesondere Xenon- und Quecksilberdampflampen. Darüber hinaus lassen sich auch Laserlichtquellen verwenden, z. B. Excimerlaser, insbesondere KrF- oder ArF-Laser, die bei 248 bzw. 193 nm emittieren. Die Strahlungsquellen müssen in den genannten Wellenlängenbereichen eine ausreichende Emission aufweisen.

Die Stärke der lichtempfindlichen Schicht hängt vom Verwendungszweck ab. Sie beträgt im allgemeinen zwischen 0,1 und 100 µm, bevorzugt zwischen 0,5 und 10 µm, besonders bevorzugt um 1,0 µm.

Das strahlungsempfindliche Aufzeichnungsmaterial wird zweckmäßig durch Auftragen des strahlungsempfindlichen Gemisches auf das Substrat, z.B. durch Aufsprühen, Fließbeschichten, Walzen, Schleuder- und Tauchbeschichten hergestellt. Danach wird das Lösemittel durch Verdampfen entfernt, so daß auf der Oberfläche des Substrats die strahlungsempfindliche Schicht zurückbleibt. Die Entfernung des Lösemittels kann durch Erhitzen der Schicht auf Temperaturen bis zu 150 °C gefördert werden. Das Gemisch kann aber auch zunächst auf obengenannte Weise auf einen Zwischenträger aufgetragen werden, von dem aus es unter Druck und erhöhter Temperatur auf das endgültige Trägermaterial übertragen wird. Als Zwischenträger können grundsätzlich alle auch als Trägermaterialien geeigneten Materialien Anwendung finden. Anschließend wird die Schicht bildmäßig bestrahlt. Danach behandelt man die Schicht mit einer Entwicklerlösung, die die bestrahlten Bereiche der Schicht löst und entfernt, so daß ein Abbild der bei der bildmäßigen Bestrahlung verwendeten Vorlage auf der Substratoberfläche verbleibt.

Als Entwickler eignen sich besonders wäßrige Lösungen, die Silikate, Metasilikate, Hydroxide, Hydrogen- und Dihydrogenphosphate, Carbonate oder Hydrogencarbonate von Alkalimetall-, Erdalkalimetall- und/oder Ammoniumionen enthalten, aber auch Ammoniak und dergleichen. Metallionenfreie Entwickler sind bevorzugt. Der Gehalt dieser Substanzen in der Entwicklerlösung beträgt im allgemeinen 0,1 bis 15 Gew.-%, vorzugweise 0,5 bis 5 Gew.-%, bezogen auf das Gewicht der Entwicklerlösung. Den Entwicklern können gegebenenfalls geringe Mengen eines Netzmittels zugesetzt sein, die die Ablösung der löslichen Bereiche der Schicht fördern.

Verwendung findet das erfindungsgemäße strahlungsempfindliche Gemisch bei der Herstellung von integrierten Schaltungen oder von diskreten elektrischen Bausteinen mit lithographischen Prozessen, da sie eine hohe Lichtempfindlichkeit aufweisen, besonders bei Bestrahlung mit Licht einer Wellenlänge zwischen 190 bis 300 nm. Die entwickelte Resistschicht dient dabei als Maske für die folgenden Prozeßschritte. Solche Schritte sind z. B. das Ätzen des Schichtträgers, das Implantieren von Ionen in den Schichtträger oder das Abscheiden von Metallen oder anderen Materialien auf dem Schichtträger.

Die nachstehend beschriebenen Beispiele illustrieren die Erfindung, sollen aber nicht beschränkend wirken. Gt steht dabei für Gewichtsteile, Vt für Volumenteile. Gewichtsteile verhalten sich zu Volumenteilen wie Gramm zu Kubikzentimeter.

### Synthesebeispiel

### 1,1,3,3-Tetrakis-(4-chlor-benzolsulfonyl)-propan

7,2 Gt Bis-(4-chlor-benzolsulfonyl)-methan werden in 150 Vt Ethanol dispergiert. Nacheinander werden dann 1,4 Vt einer 37 %igen Formalinlösung und zwei Tropfen Piperidin zugesetzt. Die Reaktionmischung wird anschließend 3 Stunden lang bei Raumtemperatur gerührt. Der entstandene Niederschlag wird abgesaugt, mit Ethanol gewaschen und an der Luft getrocknet. Der Schmelzpunkt des Produkts liegt bei 236 - 237 °C. Die Elementaranalyse ergab die folgenden Werte:

| | | | | |
|---|---|---|---|---|
| ber.: | C 43,7 % | H 2,7 % | S 17,2 % | Cl 19,1 |
| gef.: | C 43,7 % | H 2,7 % | S 16,9 % | Cl 19,2 |

Auf analoge Weise lassen sich auch die anderen Tetrasulfonyl-alkane der allgemeinen Formel herstellen.

### Beispiel 1

Es wurde eine Beschichtungslösung hergestellt aus
- 25 Gt: eines Copolymeren aus Styrol und 4-Hydroxy-styrol (20/80) mit einem mittleren Molekulargewicht von 32.000 [bestimmt durch Gelpermeationschromatographie (GPC)],
- 10,7 Gt: 3,4-Dimethoxy-benzaldehyd-(bis-phenoxyethyl-acetal) und
- 0,33 Gt: 1,1,3,3-Tetrakis-(4-chlorbenzolsulfonyl)-propan in
- 100 Gt: Propylenglykol-monomethylether-acetat.

Die Beschichtungslösung wurde durch ein Filter mit einem Porendurchmesser von 0,2 µm filtriert und auf einen mit einem Haftvermittler (Hexamethyldisilazan) vorbehandelten Wafer bei einer Drehzahl von 3000 U/min aufgeschleudert. Nach 1 min Trocknen bei 120 °C auf der hot plate wurde eine Schichtdicke von 1,21 µm erhalten.

Das Aufzeichnungsmaterial wurde bildmäßig unter einer Vorlage mit der UV-Strahlung einer Xenon-Quecksilberdampflampe (248 nm) mit einer Energie von 51 mJ/cm² bestrahlt und anschließend bei 80 °C 1 min lang einem post exposure bake auf einer hot plate unterzogen.

Entwickelt wurde das Aufzeichnungsmaterial mit einer 0,15 n wäßrigen Tetramethylammoniumhydroxid-Lösung. Nach einer Entwicklungsdauer von 60 s erhielt man ein fehlerfreies Abbild der Maske mit steilen Resistflanken, wobei auch Strukturen von bis zu 1,0 µm detailgetreu aufgelöst waren. Die rasterelektronenmikroskopische Untersuchung ergab, daß die Flanken der Resistprofile praktisch senkrecht zur Substratoberfläche ausgerichtet waren.

### Beispiel 2:

Ein wie im Beispiel 1 beschichteter Wafer wurde unter einer Vorlage mit der UV-Strahlung eines KrF-Excimer-Lasers (248 nm) mit einer Energie von 49 mJ/cm² bestrahlt. Wie im vorangehenden Beispiel wurde ein originalgetreues Abbild der Vorlage erhalten, in dem auch Strukturen von weniger als 1 µm aufgelöst waren.

### Beispiel 3:

Es wurde eine Beschichtungslösung hergestellt aus
- 25 Gt: eines Copolymeren aus 3-Methyl-4-hydroxy-styrol und 4-Hydroxystyrol (2:1) mit einem mittleren Molekulargewicht von 16.500 g/mol,
- 10,7 Gt: eines N,O-Polyacetals, hergestellt aus Benzaldehyd und N-Propyl-carbamidsäure-(2-hydroxyethyl-ester) mit einem mittleren Molekulargewicht von 5.000 g/mol, und
- 0,66 Gt: Bis-(3-chlor-benzolsulfonyl) -methan in
- 100 Gt: Propylenglykol-monoethylether-acetat.

Die Beschichtungslösung wurde durch ein Filter mit einem Porendurchmesser von 0,2 µm filtriert und auf einen mit einem Haftvermittler (Hexamethyldisilazan) vorbehandelten Wafer bei einer Drehzahl von 3500 U/min aufgeschleudert. Nach 1 min Trocknen bei 120 °C auf der hot plate wurde eine Schichtdicke von 1,07 µm erhalten.

Das Aufzeichnungsmaterial wurde bildmäßig unter einer Vorlage mit der UV-Strahlung eine KrF-Excimer-Lasers (248 nm) mit einer Energie von 33 mJ/cm² bestrahlt und anschließend 1 min lang bei 60 °C thermisch nachbehandelt.

Entwickelt wurde dann mit einer 0,27 n wäßrigen Tetramethylammoniumhydroxid-Lösung. Nach 60 s waren die bestrahlten Bereiche restlos abgelöst. Es wurde ein detailgetreues Abbild der Vorlage mit steilen Resistflanken erhalten. Die Auflösung der Linien und Gräben betrug bis zu 0,35 µm.

### Beispiel 4:

Es wurde eine Beschichtungslösung hergestellt aus
- 25 Gt: eines Homopolymeren aus 3-Methyl-4-hydroxy-styrol mit einem mittleren Molekulargewicht von 17.000 g/mol,
- 10,7 Gt: eines Polyacetals, hergestellt aus Benzaldehyd und 4-Hydroxy-buttersäure-butylamid mit einem mittleren Molekulargewicht von 6.000 g/mol, und
- 0,66 Gt: 2,2-Bis-(phenylmethansulfonyl)-propan in
- 100 Gt: Propylenglykol-monomethylether-acetat.

Die Beschichtungslösung wurde durch ein Filter mit einem Porendurchmesser von 0,2 µm filtriert und auf einen mit einem Haftvermittler (Hexamethyldisilazan) vorbehandelten Wafer bei einer Drehzahl von 3000 U/min aufgeschleudert. Nach 1 min Trocknen bei 120 °C auf der hot plate wurde eine Schichtdicke von 1,10 µm erhalten.

Der beschichtete Wafer wurde bildmäßig unter einer Vorlage mit der UV-Strahlung einer Xenon-Quecksilberdampflampe (248 nm) mit einer Energie von 35 mJ/cm² bestrahlt und anschließend 1 min lang bei 60 °C thermisch nachbehandelt.

Entwickelt wurde dann mit einer 0,27 n wäßrigen Tetramethylammoniumhydroxid-Lösung. Nach 60 s waren die bestrahlten Bereiche restlos abgelöst. Es wurde ein detailgetreues Abbild der Vorlage mit rechtwinkligen Resistflanken erhalten. Details mit einer Größe von weniger als 0,7 µm waren noch exakt wiedergegeben. Der Dunkelabtrag betrug weniger als 20 nm.

### Beispiel 5:

Es wurde eine Beschichtungslösung hergestellt aus
- 25 Gt: eines Copolymeren aus 3-Methyl-4-hydroxystyrol und 4-Hydroxystyrol (Molverhältnis 1:1) mit einem mittleren Molekulargewicht von 15.000 g/mol (GPC),
- 10,7 Gt: eines Poly-orthoesters, hergestellt durch Kondensation von 1 mol 7,7-Bis-hydroxymethyl-nonan-l-ol mit 1 mol ortho-Ameisensäure-trimethylester, und
- 0,44 Gt: 1,1,1-Tris-(4-brom-benzolsulfonyl)-ethan in
- 100 Gt: Propylenglykol-monomethylether-acetat.

Die Beschichtungslösung wurde durch ein Filter mit einem Porendurchmesser von 0,2 µm filtriert und auf einen mit einem Haftvermittler (Hexamethyldisilazan) vorbehandelten Wafer bei einer Drehzahl von 3500 U/min aufgeschleudert. Nach 1 min Trocknen bei 120 °C auf der hot plate wurde eine Schichtdicke von 1,03 µm erhalten.

Der beschichtete Wafer wurde bildmäßig unter einer Vorlage mit der UV-Strahlung einer Xenon-Quecksilberdampflampe (248 nm) mit einer Energie von 43 mJ/cm² bestrahlt und anschließend 1 min lang auf einer hot plate bei 70 °C thermisch nachbehandelt.

Entwickelt wurde dann mit einer 0,17 n wäßrigen Tetramethylammoniumhydroxid-Lösung. Nach 60 s bei 21 °C waren die bestrahlten Bereiche restlos abgelöst. Es wurde ein detailgetreues Abbild der Vorlage erhalten. Linien und Gräben waren bis in eine Größenordnung von weniger als 1 µm exakt wiedergegeben.

### Beispiel 6:

Es wurde eine Beschichtungslösung hergestellt aus
- 25 Gt: eines Copolymeren aus 3-Methyl-4-hydroxystyrol und 4-Hydroxystyrol (Molverhältnis 2:1) mit einem mittleren Molekulargewicht von 16.500 g/mol (GPC),
- 10,7 Gt: eines Poly-N,O-acetals, hergestellt aus Benzaldehyd und N-Propyl-carbamidsäure-(2-hydroxyethyl-ester), mit einem mittleren Molekulargewicht von 5.000 g/mol, und
- 0,66 Gt: 1,2-Bis-benzolsulfonyl-ethan in
- 100 Gt: Propylenglykol-monoethylether-acetat.

Die Beschichtungslösung wurde durch ein Filter mit einem Porendurchmesser von 0,2 µm filtriert und auf einen mit einem Haftvermittler (Hexamethyldisilazan) vorbehandelten Wafer bei einer Drehzahl von 3500 U/min aufgeschleudert.

Nach 1 min Trocknen bei 120 °C auf der hot plate wurde eine Schichtdicke von 1,07 µm erhalten.

Der beschichtete Wafer wurde bildmäßig unter einer Vorlage mit der UV-Strahlung eines KrF-Excimer-Lasers (248 nm) mit einer Energie von 27 mJ/cm² bestrahlt und anschließend 1 min lang auf einer hot plate bei 60 °C thermisch nachbehandelt.

Entwickelt wurde dann mit einer 0,27 n wäßrigen Tetramethylammoniumhydroxid-Lösung. Nach 60 s bei 21 °C waren die bestrahlten Bereiche restlos abgelöst. Es wurde ein detailgetreues Abbild der Vorlage mit steilen Resistflanken erhalten. Linien und Gräben waren bis in eine Größenordnung von 0,4 µm exakt wiedergegeben.

### Beispiele 7 und 8 (Vergleichsbeispiele)

Die Resistformulierung des Beispiels 5 wurde derart abgeändert, daß die dort verwendete säurebildende Verbindung durch die gleiche Menge an Triphenylsulfonium-hexafluorphosphat (Beispiel 7) oder 2-Nitro-benzyltosylat (Beispiel 8) ersetzt wurde.

Nach Bestrahlung bei 248 nm mit einer Energie von 56 mJ/cm² (Beispiel 7) bzw. 78 mJ/cm² (Beispiel 8) und nachfolgender Entwicklung wie im Beispiel 1 beschrieben wurde ein Resistbild erhalten, das keine praxisgerechte Bilddifferenzierung und damit keine akzeptablen Strukturen zeigte. Dem gemäß Vergleichsbeispiel 7 erhaltenen Resistbild hafteten noch Resistspuren in den bestrahlten Bereichen an. In den gemäß Vergleichsbeispiel 8 erhaltenen Resistbildern waren die Oberflächen der Strukturen überbrückt.

## Patentansprüche

1. Positiv-arbeitendes strahlungsempfindliches Gemisch mit
a) einer Verbindung, die unter Einwirkung von aktinischer Strahlung Säure bildet,
b) einer Verbindung mit mindestens einer durch diese Säure spaltbaren C-O-C- oder C-O-Si-Bindung und
c) einem in Wasser unlöslichen, in wäßrig-alkalischen Lösungen löslichen oder zumindest quellbaren polymeren Bindemittel,
das dadurch gekennzeichnet ist, daß die Verbindung (a) der allgemeinen Formel
R¹(-SO₂-R²)ₙ
entspricht, worin
R¹ ein n-wertiger (C₁-C₃)Alkanrest ist,
R² gleich oder verschieden sind und Aryl-, Aralkyl-, Heteroaryl- oder Heteroaralkylreste und
n eine ganze Zahl von 2 bis 4 bedeuten.

2. Strahlungsempfindliches Gemisch gemäß Anspruch 1, dadurch gekennzeichnet, daß in der Verbindung der allgemeinen Formel der Rest R¹ Methylen, Ethan-1,1-diyl, Ethan-1,2-diyl, Propan-1,2-diyl, Isopropyliden, Propan-1,3-diyl, Methantriyl, Ethan-1,1,1-triyl oder Ethan-1,1,2-triyl oder Propan-1,1,3,3-tetrayl, besonders bevorzugt Methylen, Ethan-1,2-diyl oder Propan-1,3-diyl,ist.

3. Strahlungsempfindliches Gemisch gemäß Anspruch 1, dadurch gekennzeichnet, daß in der Verbindung der allgemeinen Formel der Rest R¹ substituiert ist mit Alkyl-, Cycloalkyl-, Aryl-, Heteroaryl- und/oder Acylresten.

4. Strahlungsempfindliches Gemisch gemäß Anspruch 1, dadurch gekennzeichnet, daß in der Verbindung der allgemeinen Formel der Rest R² Phenyl, Naphthalin-1-yl, Naphthalin-2-yl oder Benzyl ist.

5. Strahlungsempfindliches Gemisch gemäß Anspruch 1, dadurch gekennzeichnet, daß in der Verbindung der allgemeinen Formel der Rest R² substituiert ist mit geradkettigen oder verzweigten (C₁-C₄)Alkyl- oder (C₁-C₄)Alkoxyresten, Alkoxyalkyl, Alkanoyl, Alkanoylamino, Carboxy, Aryl, Aryloxy, Aroyl, Aroylamino, Aralkoxy, Cyano, Nitro, Fluor-, Chlor- und/oder Bromatomen.

6. Strahlungsempfindliches Gemisch gemäß Anspruch 1, dadurch gekennzeichnet, daß der Anteil an säurebildenden Verbindungen insgesamt wie auch der an Verbindungen der allgemeinen Formel bei 0,5 bis 25 Gew.-%, bevorzugt bei 1 bis 10 Gew.-%, jeweils bezogen auf das Gesamtgewicht der nichtflüchtigen Bestandteile im Gemisch, liegt.

7. Strahlungsempfindliches Gemisch gemäß einem oder mehreren der Ansprüche 1 bis 6, dadurch gekennzeichnet, daß der Anteil der Verbindung(en) b) bei 1 bis 50 Gew.-%, bevorzugt 10 bis 40 Gew.-%, jeweils bezogen auf das Gesamtgewicht der Feststoffe des strahlungsempfindlichen Gemisches, liegt.

8. Strahlungsempfindliches Gemisch gemäß einem oder mehreren der Ansprüche 1 bis 7, dadurch gekennzeichnet, daß der Anteil des Bindemittels bei 1 bis 98,5 Gew.-%, bevorzugt 25 bis 90 Gew.-%, besonders bevorzugt 50 bis 80 Gew.-%, jeweils bezogen auf das Gesamtgewicht der Feststoffe des strahlungsempfindlichen Gemisches, liegt.

9. Positiv-arbeitendes strahlungsempfindliches Aufzeichungsmaterial, bestehend aus einem Träger mit einer strahlungsempfindlichen Schicht, dadurch gekennzeichnet, daß die Schicht aus einem Gemisch gemäß einem oder mehreren der Ansprüche 1 bis 8 besteht.

## Claims

1. A positive-working radiation-sensitive mixture comprising
a) a compound which forms acid on exposure to actinic
radiation, b) a compound containing at least one C-O-C or C-O-Si
bond which can be cleaved by said acid and c) a polymeric binder which is insoluble in water but soluble or at least swellable in aqueous alkaline solutions,
wherein the compound a) corresponds to the formula
R¹(-SO₂-R²)ₙ
in which
R¹ is an n-valent (C₁-C₃)alkane radical,
R² denotes identical or different aryl, aralkyl, heteroaryl or heteroaralkyl radicals and
n is an integer from 2 to 4.

2. A radiation-sensitive mixture as claimed in claim 1, wherein, in the compound of the formula, the radical R¹ is methylene, 1,1-ethanediyl, 1,2-ethanediyl, 1,2-propanediyl, isopropylidene, 1,3-propanediyl, methanetriyl, 1,1,1-ethanetriyl or 1,1,2-ethanetriyl or 1,1,3,3-propanetetrayl, particularly preferably methylene, 1,2-ethanediyl or 1,3-propanediyl.

3. A radiation-sensitive mixture as claimed in claim 1, wherein, in the compound of the formula, the radical R¹ is substituted by alkyl, cycloalkyl, aryl, heteroaryl and/or acyl radicals.

4. A radiation-sensitive mixture as claimed in claim 1, wherein, in the compound of the formula, the radical R² is phenyl, 1-naphthyl, 2-naphthyl or benzyl.

5. A radiation-sensitive mixture as claimed in claim 1, wherein, in the compound of the formula, the radical R² is substituted by straight-chain or branched (C₁-C₄)-alkyl or (C₁-C₄)alkoxy radicals, alkoxyalkyl, alkanoyl, alkanoylamino, carboxy, aryl, aryloxy, aroyl, aroylamino, aralkoxy, cyano, nitro groups, fluorine, chlorine and/or bromine atoms.

6. A radiation-sensitive mixture as claimed in claim 1, wherein the proportion of acid-forming compounds in total and also that of compounds of the formula is 0.5 to 25% by weight, preferably 1 to 10% by weight, based in each case on the total weight of the nonvolatile components in the mixture.

7. A radiation-sensitive mixture as claimed in one or more of claims 1 to 6, wherein the proportion of the compound(s) b) is 1 to 50% by weight, preferably 10 to 40% by weight, based in each case on the total weight of the solids in the radiation-sensitive mixture.

8. A radiation-sensitive mixture as claimed in one or more of claims 1 to 7, wherein the proportion of the binder is 1 to 98.5% by weight, preferably 25 to 90% by weight, particularly preferably 50 to 80% by weight, based in each case on the total weight of the solids in the radiation-sensitive mixture.

9. A positive-working radiation-sensitive recording material comprising a substrate having a radiation-sensitive layer, wherein the layer is composed of a mixture as claimed in one or more of claims 1 to 8.

## Revendications

1. Mélange sensible aux radiations travaillant en positif comprenant
a) un composé qui forme un acide sous l'action de rayonnements actiniques,
b) un composé comprenant au moins une liaison C-O-C ou C-O-Si clivable par cet acide et
c) un liant polymère insoluble dans l'eau, soluble ou au moins susceptible de gonfler dans une solution aqueuse alcaline,
caractérisé en ce que le composé (a) correspond à la formule générale
R¹(-SO₂-R²)ₙ
dans laquelle
R¹ est un groupe alcane (C₁-C₃) n-valent,
R² sont identiques ou différents et représentent des groupes aryle, aralkyle, hétéroaryle ou hétéroaralkyle et
n représente un nombre entier de 2 à 4.

2. Mélange sensible aux radiations selon la revendication 1, caractérisé en ce que, dans un composé de formule générale, le groupe R¹ est un groupe méthylène, éthan-1,1-diyle, éthan-1,2-diyle, propan-1,2-diyle, isopropylidène, propan-1,3-diyle, méthantriyle, éthan-1,1,1-triyle ou éthan-1,1,2-triyle ou propan-1,1,3,3-tétrayl, de préférence méthylène, éthan-1,2-diyle ou propan-1,3-diyle.

3. Mélange sensible aux radiations selon la revendication 1, caractérisé en ce que, dans le composé de formule générale, le groupe R¹ est substitué par des groupes alkyle, cycloalkyle, aryle, hétéroaryle et/ou acyle.

4. Mélange sensible aux radiations selon la revendication 1, caractérisé en ce que dans le composé de formule générale, le groupe R² est un groupe phényle, naphtalèn-1-yle, naphtalèn-2-yle ou benzyle.

5. Mélange sensible aux radiations selon la revendication 1, caractérisé en ce que, dans le composé de formule générale, le groupe R² est substitué par des groupes alkyles (C₁-C₄) ou alcoxy (C₁-C₄) linéaires ou ramifiés, des groupes alcoxyalkyle, alcanoyle, alcanoylamino, carboxy, aryle, aryloxy, aroyle, aroylamino, aralcoxy, cyano, nitro, des atomes de fluor, de chlore et/ou de brome.

6. Mélange sensible aux radiations selon la revendication 1, caractérisé en ce que la proportion du composé capable de former un acide ainsi que celle du composé de formule générale est de 0,5 à 25 % en poids, de préférence de 1 à 10 % en poids, chaque fois par rapport au poids total des composés non volatiles du mélange.

7. Mélange sensible aux radiations selon une ou plusieurs des revendications 1 à 6, caractérisé en ce que la proportion du (des) composé(s) (b) est de 1 à 50 % en poids, de préférence de 10 à 40 % en poids, chaque fois par rapport au poids total des solides du mélange sensible aux radiations.

8. Mélange sensible aux radiations selon une ou plusieurs des revendications 1 à 7, caractérisé en ce que la proportion du liant est de 1 à 98,5 % en poids, de préférence de 25 à 90 % en poids, en particulier de 50 à 80 % en poids, chaque fois par rapport au poids total des solides du mélange sensible aux radiations.

9. Matériau d'enregistrement sensible aux radiations travaillant en positif, composé d'un support recouvert d'une couche sensible aux radiations, caractérisé en ce que la couche est composée d'un mélange selon une ou plusieurs des revendications 1 à 8.
